# EUROPEAN PATENT SPECIFICATION

(11) **EP 0 459 807 B1**
(45) Date of publication and mention of the grant of the patent: **08.02.1995**
(21) Application number: 91304903.7
(22) Date of filing: 30.05.1991
(51) Int. Cl.: C23C 16/26, C23C 16/00, C23C 16/56

(54) **Industrial diamond coating and method of manufacturing the same**
Industrielle Diamant-Beschichtung und Verfahren zu ihrer Herstellung
Revêtement de diamant à usage industriel et méthode pour son obtention

(30) Priority: 30.05.1990 JP 140226/90
(43) Date of publication of application: 04.12.1991
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku, Tokyo 157 (JP); Kadono, Masaya, Atsugi-shi, Kanagawa-ken 243 (JP)
(74) Representative: Milhench, Howard Leslie

(56) References cited:
- EP-A- 0 207 467
- EP-A- 0 319 926
- EP-A- 0 402 671
- EP-A- 0 449 025
- US-A- 4 919 974
- PATENT ABSTRACTS OF JAPAN vol. 13, no. 523 (C-657)(3871) November 21, 1989; & JP-A-12 12 767
- EXTENDED ABSTRACTS, vol. 89/1, no. 105, May 7, 1989, page 153, PRINCETON, NEW JERSEY, US; L.S. PLANO ET AL: "OXIDATION OF CVD DIAMOND FILMS"

## Description

### Field of the Invention

The present invention relates to an industrial diamond thin film coating and a method of manufacturing the same.

### Description of the Prior Art

The lifetime of machine tools such as cutting tools, grinding tools and other instruments having very hard surfaces or abrasive edges can be prolonged by coating protective films made of very hard materials such as diamond, titanium carbide, titanium nitride, carbonated titanium nitride, and aluminium oxide for example directly onto the hard surfaces or abrasive edges. Diamond coatings in particular have been considered to be very effective for coating surfaces made of nonferrous metals or ceramics.

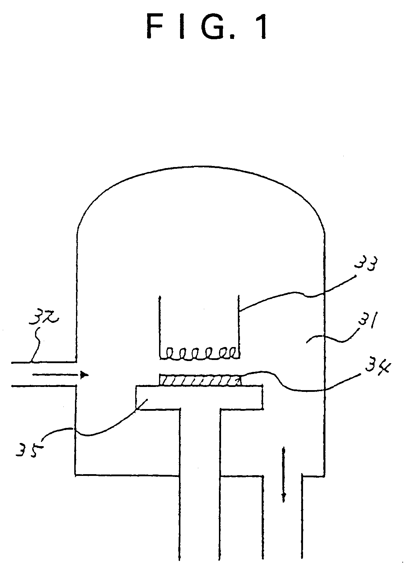

Such coatings have typically been formed on surfaces of the tools by thermal CVD (chemical vapor deposition) in an apparatus as illustrated in Fig.1 of the accompanying drawings. This apparatus comprises a vacuum chamber 31, a tungsten filament 33 and a holder 35. After mounting an object 34 on the holder 35, a large electric current is caused to pass through the filament 33 in order to emit thermal electrons at 1500°C to 1300°C. A reactive gas comprising carbon is introduced into the chamber from an inlet port 32 at the same time. By virtue of the thermal electrons, the reactive gas is decomposed so as to cause the object 34 to be coated with a diamond film. During coating, the temperature of the object 34 is kept at 400°C to 1300°C and the pressure in the chamber at 133-46,667 Nm⁻² (1 Torr to 350 Torr). A similar method is described in US-A-4 919 974.

One of the practical problems of this technique is the separation or rubbing off of the diamond film from the surface of the tool. Until now, sufficient adhesivity of diamond coatings to the surfaces of tools has not been accomplished. The difference in thermal expansion coefficient between the diamond film and the underlying surface has been considered to be a cause of separation of the diamond film from the surface.

Furthermore, it is another shortcoming of the prior art techniques that diamond coatings could only be deposited on very small areas so that diamond coated tools become very expensive. Still further, because of undesirable disparities in film quality, practical applications of these techniques have been substantially limited.

Methods of forming a diamond film on a temporary substrate and then attaching the film to the required surface are known, for example, from EP-A-0 319 926. EP-A-0 449 025 discloses similar methods.

### SUMMARY OF THE INVENTION

Thus the present invention aims to overcome or at least substantially reduce the abovementioned problems and to enable the provision of a diamond thin film coating on an article, and a method of manufacturing the same, which exhibits substantial adhesivity to and can hardly be separated from the underlying surface.

The present invention also aims to provide such a diamond thin film coating and a method of manufacturing the same at a low production cost.

To achieve the above, the present invention provides a method of forming an industrial diamond coating on a surface, said method comprising: forming said diamond coating on a substrate; and adhering the diamond coating to said surface, as is known for example from EP-A-0 319 926, characterized in accordance with the invention by removing carbon in forms other than diamond from said coating; and filling the resultant void spaces occurring in said coating after such removal with a heat resistant material.

The substrate may, if desired, be removed from the diamond film which remains fixed to the object to provide a hard surface coating for the same. When the object is a cutting tool, it is desirable that the tool be made from a material having a high tenacity and a low thermal expansion coefficient.

As will be explained more fully hereinafter, diamond crystals grown on a substrate in the form of a thin film develop in inverted conical shapes. The contact areas of the crystals to the underlying surface of the substrate are thus very small because of the inversion of the cones, resulting in poor adhesivity of the diamond crystals to the substrate. The substrate with its diamond film coating is then joined to the surface of an object, for example by soldering the diamond film to the object, and then the substrate is eliminated from the diamond film, for example by mechanical grinding. As will readily be appreciated, the contact areas of the conical diamond crystals to the surface of the object are substantially increased by this procedure which ensures that the larger ends of the diamond crystals are adhered to the object. The mechanical strength of the bond between the diamond coating and the object can thus be greatly improved. Accordingly, the method of the invention is very effective for many applications.

When the above method of the invention is applied to the coating of devices which produce a great amount of frictional heat during machining, such as in the case of some grinding tools for example, the measures to eliminate carbon in a form other than diamond from the diamond coating, and to fill any void spaces occurring in the diamond coating after such elimination with a heat-resistant material inhibit the diamond coating from rubbing off of the device.

The above described measures result from the discovery that rubbing off of the diamond coating can be caused by carbon material occurring in the diamond coating but deposited in structures other than diamond, such as amorphous carbon or graphite for example which easily comes off the surface of an object if the temperature rises beyond 300°C. By virtue of these measures in accordance with the present invention, the diamond coating consists only of pure diamond crystals with a heat-resistant filling material so that separation of the coating from the host object is unlikely to occur even at high temperatures.

The above and further features of the present invention are set forth with particularity in the appended claims and, together with the advantages thereof, will become clear from consideration of the following description given with reference to the accompanying drawings.

### BRIEF DESCRIPTION OF THE DRAWINGS

Fig. 1 shows a thermal CVD apparatus as conventionally used for forming a diamond coating on an object;
Fig. 2 is a schematic diagram showing a microwave assisted CVD apparatus which can be used for forming a diamond coating in accordance with the teachings of the present invention;
Figs. 3(A) to 3(C) are cross-sectional views showing the formation of a diamond coating in accordance with the teachings of EP-A-0 449 025;
Figs. 4(A) to 4(E) are cross-sectional views showing the formation of a diamond coating in accordance with the present invention;
Figs. 5 and 6 are graphical diagrams showing the advantages of the present invention;
Fig. 7 is a cross-sectional view showing a diamond coating in accordance with the present invention after use for machining;
Figs. 8(A) to 8(D) are cross-sectional views showing a further method of forming a diamond coating in accordance with the present invention;
Figs. 9(A) and 9(B) are explanatory views showing a modification of the present invention; and
Figs. 10(A) and 10(B) are explanatory views showing another modification of the present invention.

### DETAILED DESCRIPTION OF THE EMBODIMENTS

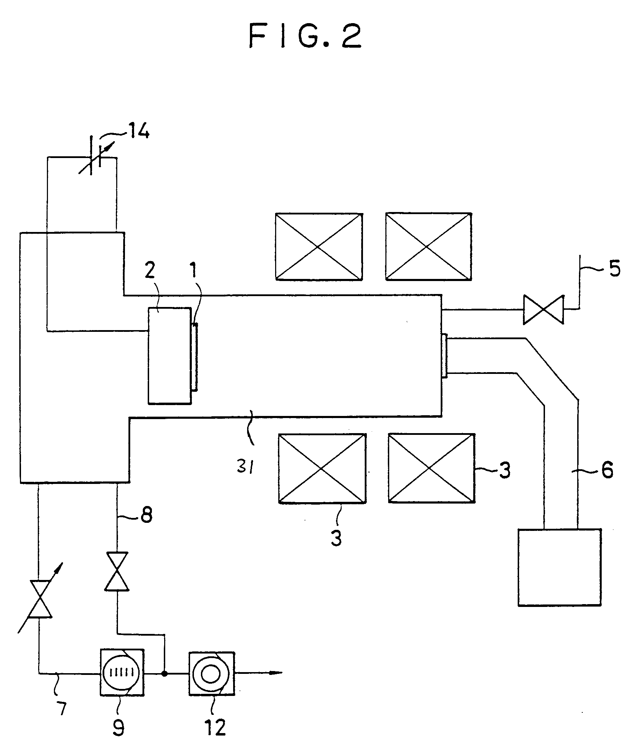

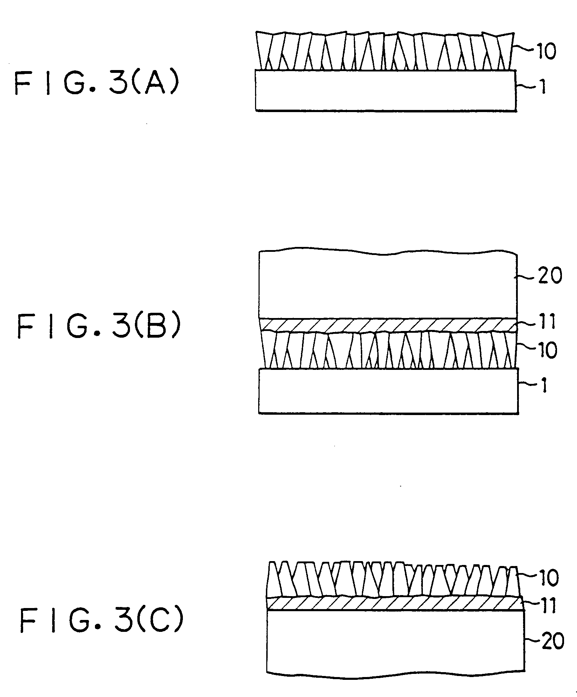

Referring now to Fig. 2 and Figs. 3(A) to 3(C), a method of manufacturing a diamond coating will be explained.

Fig. 2 illustrates a microwave assisted CVD apparatus for effecting the deposition of diamond in a magnetic field. The apparatus comprises a vacuum chamber 31, a holder 2 provided in the chamber 31, a voltage source 4 for applying a suitable bias voltage to the holder 2, a microwave generator 6 coupled with the chamber 31, a gas introduction system 5 for introducing a reactive gas into the chamber 31, Helmholtz coils 3 surrounding the chamber 31 and an evacuation system 7 including a turbo molecular pump 9 and a rotary pump 12 for maintaining the pressure in the chamber at an appropriate level and removing exhausted gas therefrom.

After mounting a substrate 1 to be coated on the holder 2 in the chamber 31 and evacuating the chamber 31 by means of the system 7, a reactive gas consisting of methanol (50ccm) and hydrogen (100ccm) is introduced into the chamber from the gas introduction system 5. The strength of the magnetic field induced by the coils 3 is controlled at a suitable level, e.g. 875 Gauss or higher, at the substrate surface. Microwave energy (2.45GHz) is inputted from the generator 6 at 4 kW. The reactive gas is then activated into a high energy plasma and decomposed so as to cause diamond crystals to grow on the surface of the substrate 1 at a reaction pressure of 33.3 Nm⁻² (0.25 Torr). The temperature of the substrate 1 is kept at 800°C during the deposition process. By this means, a 10»m thick diamond film will be formed on the substrate over a period of 20 hours. The surface of the substrate is scratched beforehand to provide seeds for crystal growth thereon by ultrasonic treatment for ten minutes in a solution in which diamond particles for example of 10»m to 200»m diameter, for example 30»m to 40»m, are dispersed. The substrate may for example be a silicon semiconductor wafer of 10cm diameter.

The use of a deposition method of this type is very desirable because the deposition area can be increased to ⌀ 10cm or more, which is greater than that of the conventional method by a factor of 20 or more.

Fig. 3(A) is a diagram showing a cross-sectional view of the diamond crystals grown from the substrate 1 in the form of a thin film as designated by numeral 10. As shown in the figure, the crystals are grown in inverted conical shapes. The contact areas of the crystals to the underlying surface of the substrate are very small because of the inversion of the cones, resulting in poor adhesivity.

The substrate 1 coated with the diamond film 10 is then removed from the chamber and joined to the surface of an object 20 to be reinforced by the diamond film by means of a solder 11, such as gold solder for example, as shown in Fig. 3(B). The object may, for example, be a grinder made of tungsten carbide. Other adhesive can be used in place of the solder such as a suitable heat-resistant strong adhesive, for example, an epoxy/phenolic or nitrile/phenolic adhesive. The surface of the diamond film 10 may if desired be subjected to a plasma or sand blast treatment in advance of its joining to the object in order to enhance its adhesivity to the object 20. Finally, the substrate 1 is eliminated from the diamond film 10 by mechanical grinding as shown in Fig. 3(C).

As may easily be understood from Fig. 3(C), the contact areas between the diamond crystals 10 and the surface of the object 20 are substantially increased by this procedure so that the mechanical strength of the bond between the coating and the object can be greatly improved, this resulting also from the effect of the adhesive. In accordance with experiments that we have conducted, the lifetime of grinding tools provided with diamond coatings in accordance with the teachings of the above was prolonged by a factor of 5 or more as compared with conventional products.

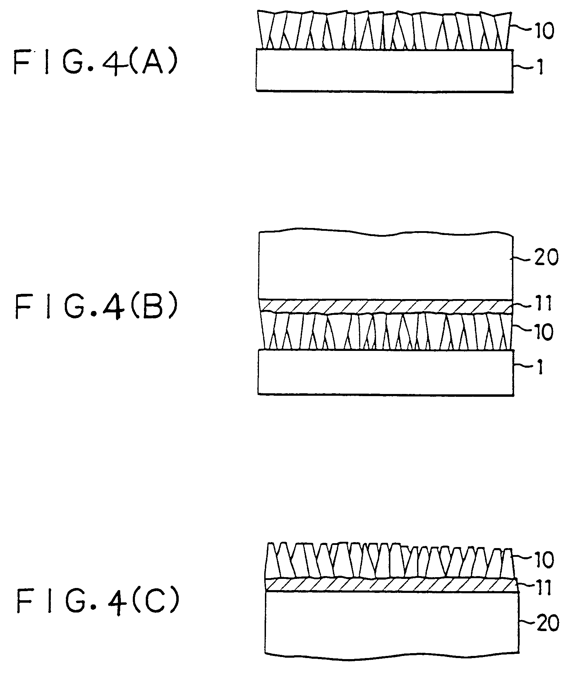

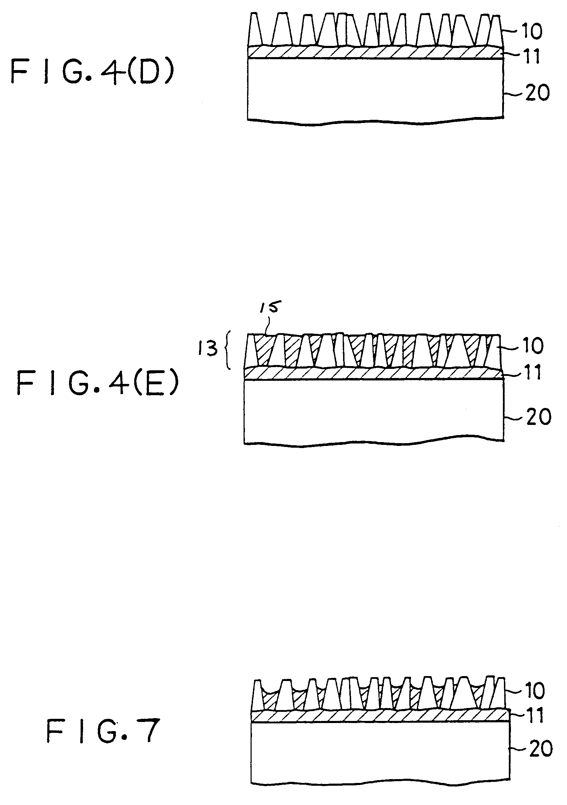

Referring now to Figs. 4(A) to 4(E), these show the formation of a diamond coating on an object by a process as above described which further includes the removal of softer non-diamond forms of carbon from the deposit formed on the substrate. Figs. 4(A) to 4(C) show process steps identical to those described in the foregoing with reference to Figs. 3(A) to 3(C) save for the use of polybenzimidazole as the adhesive 11. Following removal of the substrate the object is disposed again in the apparatus shown in Fig. 2 for the purpose of carrying out plasma etching. The etchant gas is oxygen introduced into the vacuum chamber 31 at 100 SCCM. The reaction pressure of oxygen is kept at 13.3 Nm⁻² (0.10 Torr) by means of the evacuation system. The input power of the microwave energy (2.45GHz) is 4 kW. The strength of the magnetic field applied to the object is 875 Gauss or stronger. The etching action is continued for 30 minutes in order to eliminate carbon materials, such as amorphous carbon and graphite, other than diamond from the coating. Spaces are left in the coating after the elimination of these softer carbon materials as is shown in Fig. 4(D), and these spaces are filled with a heat-resistant adhesive or solder 15, e.g. polybenzimidazole, in order to provide a cohesive protecting coating 13 as shown in Fig. 4(E).

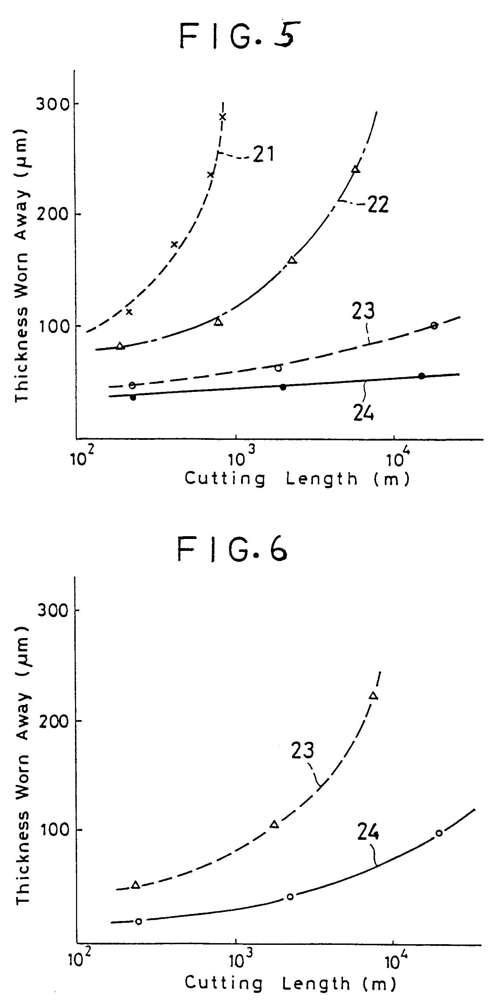

Experiments have been conducted in order to prove the effectiveness of the present invention in comparison to prior art techniques. The test was carried out by cutting the peripheral surfaces of aluminum cylinders by means of a lathe whose cutting tool was replaced by sample cutting tools made of tungsten whose edges had been selectively coated or not coated with diamond. The cutting speed of the edge turning relative to the peripheral surfaces was 400 m/min. The depth of cutting into the surfaces was 0.25 mm. The feed speed of the surface to the cutting edges was 0.1 mm/rev. Fig. 5 is a graphical diagram showing the relationship between the length of the cut surface and the thickness of the surface portion of the edge worn away due to the cutting action. Curve 21 represents the relationship in the case where the tool had no diamond coating. Curve 22 represents the relationship in the case where diamond was deposited directly on the tool by means of a conventional technique. Curve 23 represents the relationship in the case where diamond was first deposited on a substrate and thereafter transferred to the tool as shown in Figs. 3(A) to 3(C). Curve 24 represents the relationship in the case where diamond was first deposited on a substrate, then transferred to the tool, then etched and finally filled with polybenzimidazole as shown in Figs. 4(A) to 4(E). As may be seen from the diagram, by comparing curves 23 and 24 with curves 21 and 22, highly abrasion proof tools could be realized by use of cutting edges which had been provided with a diamond coating consisting of inverted diamond cones connected to the edges at their wide bottom surfaces.

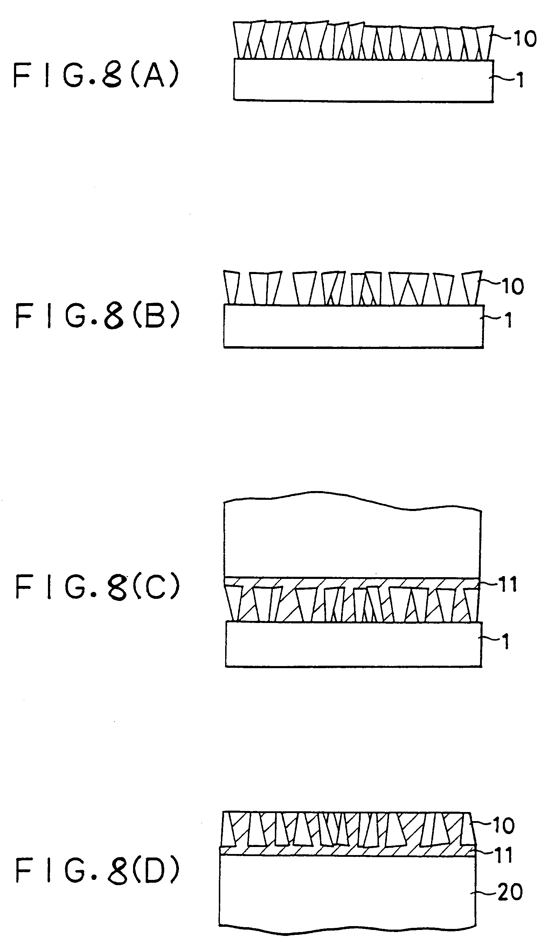

The most significant advantage of the present invention appeared when the cutting speed was increased to 1000 m/min so that the temperature of the cutting edge was elevated to about 300°C. Fig. 6 is a graphical diagram showing the relationship corresponding to Fig. 5. Curve 23 represents the relationship in the case where diamond was first deposited on a substrate and thereafter transferred to the tool as shown in Figs. 3(A) to 3(C). Curve 24 represents the relationship in the case where diamond was first deposited on a substrate, then transferred to the tool, then etched and finally filled with polybenzimidazole as shown in Figs. 4(A) to 4(E). As may be seen from the diagram, curve 23 indicates that the diamond coating substantially wore away as the cutting length increased. This is considered to happen because of the separation of amorphous carbon or graphite due to the elevated temperature resulting in void spaces between diamond crystals of the coating. Contrary to this, curve 24 indicates heat-resistance of the coating with little wear. This is considered to be due to the polybenzimidazole filler reinforcing the bases of the constituent diamond cones even after partial removal of the surface portions thereof due to abrasive action during cutting as shown in Fig. 7.

Referring now to Figs 8(A) to 8(D), a method of manufacturing a carbon coating in accordance with a further embodiment of the present invention will be explained.

Fig. 8(A) is a diagram showing a cross-sectional view of diamond crystals grown from a substrate 1 in the form of a thin film as designated by numeral 10. The deposition process is the same as for the embodiments previously described. The object is next subjected to plasma etching in the apparatus shown in Fig. 2 by changing the reactive deposition gas to an etchant gas. Namely, the deposition and etching can be carried out continuously without moving the object. The etchant gas is oxygen introduced into the vacuum chamber 31 at 100 SCCM. The reaction pressure of oxygen is kept at 13.3 Nm⁻² (0.10 Torr) by means of the evacuation system. The input power of the microwave energy (2.45 GHz) is 4 kW. The strength of the magnetic field applied to the object is 875 Gauss or stronger. The etching action is continued for 30 minutes in order to eliminate carbon materials, such as amorphous carbon and graphite, other than diamond from the coating. Then, spaces are left after the elimination in the coating as shown in Fig. 8(B).

The substrate 1, coated with the diamond film 10 consisting only of pure diamond crystals, is then joined to the surface of an object 20 to be reinforced by the diamond film by means of an adhesive made of polybenzimidazole 11 as shown in Fig. 8(C). Other adhesives can be used in place of the above, such as suitable heat-resistant strong adhesives capable of providing structural reinforcement, for example, an epoxy/phenolic or nitrile/phenolic adhesive in the same manner as hereinbefore described. The substrate 1 is then eliminated from the diamond film 10 by mechanical grinding as shown in Fig. 8(D).

As may easily be understood from Fig. 8(D), the contact areas between the diamond crystals 10 and the surface of the object 20 are substantially increased by this procedure, and the respective diamond crystals are fixed by the adhesive 11 which is not degraded even at high temperatures.

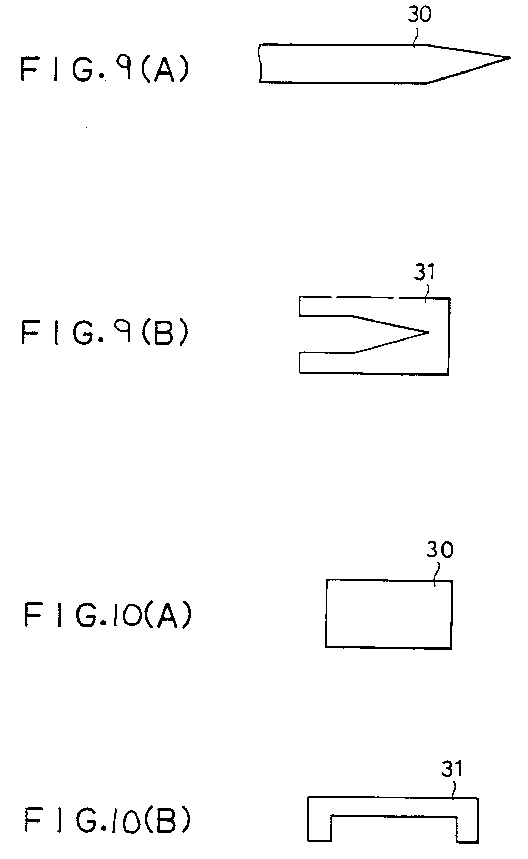

The foregoing description of preferred embodiments has been presented for purposes of illustration and is not intended to be exhaustive or to limit the invention to the precise form described, and obviously many modifications and variations are possible in light of the above teaching without departure from the scope of the invention as defined in the appended claims. For example, a variety of objects can be coated in the same manner by preparing the substrate 1 as a mold which has a surface conforming to the surface of the object to be coated. Figs. 9(A) and 9(B) illustrate an example of this modification. Fig. 9(A) shows, as an object to be coated, a cylinder 30 having a sharpened tip. For coating of such an object, a substrate 31 shown in Fig. 9(B) is used to provide an inner surface corresponding to the outer surface of the object 30. The inner surface is first coated with a diamond coating followed by the same procedure as explained above with reference to Figs. 4(A) to 4(E). Figs. 10(A) and 10(B) illustrate another example of this modification. Fig. 10(A) shows, as an object to be coated, a rectangular block 30 having an upper surface to be reinforced. For coating of such an object, a substrate 31 shown in Fig. 10(B) is used to provide an inner surface corresponding to the upper surface of the object 30 followed by the procedure as shown in Figs. 8(A) to 8(D).

The deposition method in the apparatus shown in Fig. 2 as described above is very appropriate because even if the objects have complicated surfaces, uniform diamond coatings can be deposited by this method. On the other hand, the etching of carbon material other than diamond can be appropriately carried out by means of other types of etching devices or by chemical etching such as wet etching. The etching is preferably carried out in the same chamber as the deposition because the diamond coating can be kept clean without exposure to external atmosphere. The elimination of the unnecessary substrate 1 can be done also by use of suitable chemicals (solvent) capable of dissolving the substrate.

Carbon in forms other than diamond may be eliminated from the diamond coating of the present invention by heating the diamond coating in the apparatus shown in Fig. 2 at a reduced pressure instead of etching.

Finally, elimination of the substrate may be dispensed with in order to save manufacturing time. Even if the substrate does not have sufficient hardness, a diamond coating provided between the substrate and the object can protect the object.

## Claims

1. A method of forming an industrial diamond coating (10) on a surface (20), said method comprising:
forming said diamond coating (10) on a substrate (1); and
adhering the diamond coating (10) to said surface (20)
characterized by:
removing carbon in forms other than diamond from said coating (10); and
filling the resultant void spaces occurring in said coating (10) after such removal with a heat resistant material (15).

2. A method according to claim 1, wherein said diamond coating (10) is adhered to said surface (20) prior to said removal and filling steps.

3. A method according to claim 1, wherein said diamond coating (10) is adhered to said surface (20) after said removal and filling steps.

4. A method according to any preceding claim wherein said heat resistant material 15 comprises an adhesive (11).

5. A method according to any preceding claim wherein said coating (10) is formed by deposition.

6. A method according to claim 5 wherein said deposition comprises plasma CVD.

7. A method according to any preceding claim wherein said removal step is carried out by etching.

8. A method according to claim 7 wherein said etching comprises plasma etching.

9. A method according to any preceding claim further comprising removing said substrate (1) from said diamond coating (10).

10. A method according to any preceding claim wherein said diamond coating (10) is adhered to said surface (1) by use of an adhesive (11).

11. A method according to claim 10 wherein said adhesive (11) comprises polybenzimidazole.

12. A method according to claim 10 wherein said adhesive (11) comprises an epoxy/phenolic or nitrile/phenolic adhesive.

13. A method according to any of claims 1 to 9 wherein said diamond coating (10) is adhered to said surface (1) by use of a solder (11).

14. An article having an industrial diamond coating (10) adhered to a surface (20) thereof, said coating (10) being free of carbon in forms other than diamond and wherein void spaces in said coating (10) are filled with a heat resistant material (15), said coating (10) being obtainable by a method according to any preceding claim.

## Patentansprüche

1. Verfahren zum Herstellen einer industriellen Diamantbeschichtung (10) auf einer Oberfläche (20), das folgendes aufweist:
- Ausbilden der Diamantbeschichtung (10) auf einem Substrat (1) und
- Herstellen einer Haftverbindung zwischen der Diamantbeschichtung (10) und der Oberfläche (20);
**gekennzeichnet durch:**
- Entfernen von Kohlenstoff in anderen Formen als Diamant aus der Beschichtung (10) und
- Auffüllen der sich ergebenden Ausnehmungen, wie sie in der Beschichtung (10) nach einem solchen Entfernen auftreten, mit einem wärmebeständigen Material (15).

2. Verfahren nach Anspruch 1, bei dem die Diamantbeschichtung (10) vor den Schritten des Entfernens und Auffüllens zur Anhaftung an der Oberfläche (20) gebracht wird.

3. Verfahren nach Anspruch 1, bei dem die Diamantbeschichtung (10) nach den Schritten des Entfernens und Auffüllens zur Anhaftung an der Oberfläche (20) gebracht wird.

4. Verfahren nach einem der vorstehenden Ansprüche, bei dem das wärmebeständige Material 15 ein Kleber (11) ist.

5. Verfahren nach einem der vorstehenden Ansprüche, bei dem die Beschichtung (10) durch Abscheidung hergestellt wird.

6. Verfahren nach Anspruch 5, bei dem die Abscheidung durch Plasma-CVD erfolgt.

7. Verfahren nach einem der vorstehenden Ansprüche, bei dem der Entfernungsschritt durch Ätzen ausgeführt wird.

8. Verfahren nach Anspruch 7, bei dem das Ätzen durch Plasmaätzen erfolgt.

9. Verfahren nach einem der vorstehenden Ansprüche, das ferner ein Entfernen des Substrats (1) von der Diamantbeschichtung (10) aufweist.

10. Verfahren nach einem der vorstehenden Ansprüche, bei dem die Diamantbeschichtung (10) unter Verwendung eines Klebers (11) zur Anhaftung an der Oberfläche (1) gebracht wird.

11. Verfahren nach Anspruch 10, bei dem der Kleber (11) Polybenzimidazol ist.

12. Verfahren nach Anspruch 10, bei dem der Kleber (11) ein Epoxy/Phenol- oder ein Nitril/Phenol-Kleber ist.

13. Verfahren nach einem der Ansprüche 1 bis 9, bei dem die Diamantbeschichtung (10) durch ein Lot (11) zur Anhaftung an der Oberfläche (1) gebracht wird.

14. Gegenstand mit einer industriellen Diamantbeschichtung (10) die mit einer Oberfläche (20) desselben in Haftverbindung steht, wobei die Beschichtung (10) frei von Kohlenstoff in anderen Formen als der von Diamant ist und wobei Ausnehmungen in der Beschichtung (10) mit einem wärmebeständigen Material (15) aufgefüllt sind, wobei die Beschichtung (10) durch ein Verfahren gemäß einem der vorstehenden Ansprüche erhältlich ist.

## Revendications

1. Procédé de formation d'un revêtement de diamant industriel (10) sur une surface (20), ledit procédé comprenant :
la formation dudit revêtement de diamant (10) sur un substrat (1), et
la fixation par adhérence du revêtement de diamant (10) à ladite surface (20),
caractérisé par :
l'élimination dudit revêtement (10) du carbone se présentant sous des formes autres que le diamant, et le remplissage des espaces vides résultants, apparaissant dans ledit revêtement (10) après une telle élimination, avec un matériau résistant à la chaleur (15).

2. Procédé selon la revendication 1, dans lequel ledit revêtement de diamant (10) est fixé par adhérence à ladite surface (20) avant lesdites étapes d'élimination et de remplissage.

3. Procédé selon la revendication 1, dans lequel ledit revêtement de diamant (10) est fixé par adhérence à ladite surface (20) après lesdites étapes d'élimination et de remplissage.

4. Procédé selon l'une quelconque des revendications précédentes, dans lequel ledit matériau résistant à la chaleur 15 comprend un adhésif (11).

5. Procédé selon l'une quelconque des revendications précédentes, dans lequel ledit revêtement (10) est formé par dépôt.

6. Procédé selon la revendication 5, dans lequel ledit dépôt comprend un dépôt chimique en phase vapeur au plasma.

7. Procédé selon l'une quelconque des revendications précédentes, dans lequel ladite étape d'élimination est réalisée par attaque chimique.

8. Procédé selon la revendication 7, dans lequel ladite attaque chimique comprend une attaque chimique au plasma.

9. Procédé selon l'une quelconque des revendications précédentes, comprenant en outre l'élimination dudit substrat (1) dudit revêtement de diamant (10).

10. Procédé selon l'une quelconque des revendications précédentes, dans lequel ledit revêtement de diamant (10) est fixé par adhérence à ladite surface (1) à l'aide d'un adhésif (11).

11. Procédé selon la revendication 10, dans lequel ledit adhésif (11) comprend le polybenzimidazole.

12. Procédé selon la revendication 10, dans lequel ledit adhésif (11) comprend un adhésif époxy/phénolique ou nitrile/phénolique.

13. Procédé selon l'une quelconque des revendications 1 à 9, dans lequel ledit revêtement de diamant (10) est fixé par adhérence à ladite surface (1) à l'aide d'un métal d'apport de brasage (11).

14. Objet à une surface (20) duquel un revêtement de diamant industriel (10) est fixé par adhérence, ledit revêtement (10) étant exempt de carbone sous des formes autres que le diamant, et dans lequel les espaces vides dans ledit revêtement (10) sont remplis d'un matériau résistant à la chaleur (15), ledit revêtement (10) pouvant être obtenu par un procédé selon l'une quelconque des revendications précédentes.
